# EUROPÄISCHE PATENTSCHRIFT

(11) **EP 2 841 514 B1**
(45) Veröffentlichungstag und Bekanntmachung des Hinweises auf die Patenterteilung: **19.08.2015**
(21) Anmeldenummer: 13716251.7
(22) Anmeldetag: 04.04.2013
(51) Int. Cl.: C08L 83/04, C08K 9/02, C09D 183/04

(54) **SILICONZUSAMMENSETZUNG MIT SCHADSTOFFSCHUTZ**
SILICONE COMPOSITION WITH PROTECTION AGAINST POLLUTANTS
COMPOSITIONS DE SILICONE PROTÉGÉES CONTRE LES SUBSTANCES NOCIVES

(30) Priorität: 26.04.2012 DE 102012206968
(43) Veröffentlichungstag der Anmeldung: 04.03.2015
(73) Patentinhaber: Wacker Chemie AG, 81737 München (DE)
(72) Erfinder: MÜLLER, Philipp, 84489 Burghausen (DE)
(74) Vertreter: Mieskes, Klaus Theoderich
(86) Internationale Anmeldenummer: PCT/EP2013/057146
(87) Internationale Veröffentlichungsnummer: WO 2013/160081

(56) Entgegenhaltungen:
- EP-A1- 1 039 480
- EP-A1- 1 295 905

## Beschreibung

Die Erfindung betrifft additionsvernetzende Siliconzusammensetzungen, die eine schützende Verkapselung von elektrischen und elektronischen Bauteilen ermöglicht, die einer stark korrosiven Umgebung ausgesetzt sind.

Siliconvergussmassen werden in großen Mengen zum Korrosionsschutz von elektronischen Schaltungen eingesetzt. Elektronische Bauteile werden mittlerweile auch in zunehmendem Maße besonders aggressiven, schwefelhaltigen Schadgasen ausgesetzt. Da die bislang verfügbaren Siliconvergussmassen eine hohe Permeabilität gegenüber Schwefel, Schwefelwasserstoff, Schwefeldioxid, Kohlendisulfid und anderen Schwefelorganylen aufweisen kommt es durch Korrosion der metallischen Leiterbahnen zu Ausfällen und verkürzten Lebensdauern dieser Bauteile.

EP1295905A1 beschreibt Siliconzusammensetzungen zur Verkapselung, die metallische Füllstoffe in Puderform enthalten, wobei insbesondere Cu-Puder als bevorzugt beschrieben wird. Die hier angebotene Lösung mit rein metallischen Oberflächen zeigt jedoch noch immer eine unzureichende Wirkung, da der Abfangreaktion der Schwefelgase nur eine verhältnismäßig geringe effektive Oberfläche des Metalls zur Verfügung steht. Zudem sind zahlreiche weitere Nachteile wie der hoher Preis, die hohe Dichte und negative Dämpfungseigenschaften mit dieser Lösung verbunden.

Es bestand daher die Aufgabe eine Siliconzusammensetzungen zur Verfügung zu stellen, welche die oben genannten Nachteile nicht aufzeigt und einen guten Schutz von elektronischen Bauteilen gegenüber Schwefelschadgasen zeigt.

Diese Aufgabe wurde überraschender Weise gelöst durch additionsvernetzende Siliconzusammenseztungen enthaltend,
(A) 30-95 Gew.% lineare Verbindungen, die Reste mit aliphatischen Kohlenstoff-Kohlenstoff-Mehrfachbindungen aufweisen,
(B) 0,1-20 Gew.% lineare Organopolysiloxane mit Si-gebundenen Wasserstoffatomen,
   oder anstelle von (A) und (B)
(C) 30-95 Gew.% lineare Organopolysiloxane, die SiC-gebundene Reste mit aliphatischen Kohlenstoff-Kohlenstoff Mehrfachbindungen und Si-gebundene Wasserstoffatome aufweisen,
(D) mindestens einen Hydrosilylierungskatalysator, und
(E) 5 bis 70 Gew.% Füllstoff aus porösen Glaspartikeln die mit Silber dotiert sind, wobei 5 bis 50 Gew.% des Silbers in ionischer Form dotiert sind.

Bei den erfindungsgemäßen Zusammensetzungen kann es sich um Einkomponenten-Siliconzusammensetzungen wie auch um Zweikomponenten-Siliconzusammensetzungen handeln. In letzterem Fall können die beiden Komponenten der erfindungsgemäßen Zusammensetzungen alle Bestandteile in beliebiger Kombination enthalten, im Allgemeinen mit der Maßgabe, dass eine Komponente nicht gleichzeitig Siloxane mit aliphatischer Mehrfachbindung, Siloxane mit Si-gebundenem Wasserstoff und Katalysator, also im Wesentlichen nicht gleichzeitig die Bestandteile (A), (B) und (D) bzw. (C) und (D) enthält. Vorzugsweise handelt es sich bei den erfindungsgemäßen Zusammensetzungen jedoch um Einkomponenten-Zusammensetzungen. Die erfindungsgemäßen Einkomponenten-Silconelastomerzusammensetzung werden durch vermischen der Bestandteile durch Mischen der Komponenten (A), (B), (D) und (E) oder (C), (D) und (E) nach dem Stand der Technik hergestellt.

Die in den erfindungsgemäßen additionsvernetzenden Zusammensetzungen eingesetzten Verbindungen (A) und (B) bzw. (C) werden bekanntermaßen so gewählt, dass eine Vernetzung möglich ist. So weist beispielsweise Verbindung (A) mindestens zwei aliphatisch ungesättigte Reste auf und (B) mindestens drei Si-gebundene Wasserstoffatome, oder Verbindung (A) weist mindestens drei aliphatisch ungesättigte Reste auf und Siloxan (B) mindestens zwei Si-gebundene Wasserstoffatome, oder aber anstelle von Verbindung (A) und (B) wird Siloxan (C) eingesetzt, welches aliphatisch ungesättigte Reste und Si-gebundene Wasserstoffatome in den oben genannten Verhältnissen aufweist. Auch sind Mischungen aus (A) und (B) und (C) mit den oben genannten Verhältnissen von aliphatisch ungesättigten Resten und Si-gebundenen Wasserstoffatomen möglich.

Vorzugsweise enthalten die erfindungsgemäßen Siliconzusammensetzungen als Bestandteil (A) mindestens eine aliphatisch ungesättigte lineare Organosiliciumverbindung, wobei alle bisher in additionsvernetzenden Zusammensetzungen verwendeten, aliphatisch ungesättigten linearen Organosiliciumverbindungen eingesetzt werden können.

Als Organosiliciumverbindungen (A), die SiC-gebundene Reste mit aliphatischen Kohlenstoff-Kohlenstoff-Mehrfachbindungen aufweisen, werden vorzugsweise lineare Organopolysiloxane aus Einheiten der allgemeinen Formel (II)

RₐR¹_{b}SiO_{(4-a-b)/2} (II)

eingesetzt, wobei
**R** unabhängig voneinander, gleich oder verschieden, ein von aliphatischen Kohlenstoff-Kohlenstoff-Mehrfachbindungen freien, organischen oder anorganischen Rest,
**R¹** unabhängig voneinander, gleich oder verschieden einen einwertigen, substituierten oder nicht substituierten, SiC-gebundenen Kohlenwasserstoffrest mit mindestens einer aliphatischen Kohlenstoff-Kohlenstoff-Mehrfachbindung,
**a** 1, 2 oder 3 ist, und
**b** 1 oder 2 ist
bedeuten,
mit der Maßgabe, dass die Summe a + b kleiner oder gleich 3 ist und mindestens 2 Reste R¹ je Molekül vorliegen.

Bei Rest R kann es sich um ein- oder mehrwertige Reste handeln, wobei die mehrwertigen Reste, wie beispielsweise bivalente, trivalente und tetravalente Reste, dann mehrere, wie etwa zwei, drei oder vier, Siloxy-Einheiten der Formel (II) miteinander verbinden.

Weitere Beispiele für R sind die einwertigen Reste -F, -Cl, Br, OR², -CN, -SCN, -NCO und SiC-gebundene, substituierte oder nicht substituierte Kohlenwasserstoffreste, die mit Sauerstoffatomen oder der Gruppe -C(O)- unterbrochen sein können, sowie zweiwertige, beidseitig gemäß Formel (II) Si-gebundene Reste. Falls es sich bei Rest R um SiC-gebundene, substituierte Kohlenwasserstoffreste handelt, sind bevorzugte Substituenten Halogenatome, phosphorhaltige Reste, Cyanoreste, -OR², -NR²- , -NR²₂, -NR²-C(O)-NR²₂, -C(O)-NR²₂, -C(O)R², -C(O)OR², -SO₂-Ph und -C₆F₅. Dabei bedeuten R²unabhängig voneinander, gleich oder verschieden ein Wasserstoffatom oder einen einwertigen Kohlenwasserstoffrest mit 1 bis 20 Kohlenstoffatomen und Ph gleich dem Phenylrest.

Beispiele für Reste R sind Alkylreste, wie der Methyl-, Ethyl-, n-Propyl-, iso-Propyl-, n-Butyl-, iso-Bulyl-, tert-Butyl-, n-Pentyl-, iso-Pentyl-, neo-Pentyl-, tert-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, Cycloalkylreste, wie Cyclopentyl-, Cyclohexyl-, Cycloheptyl- und Methylcyclohexylreste, Arylreste, wie der Phenyl-, Naphthyl-, Anthryl- und Phenanthrylrest, Alkarylreste, wie o-, m-, p-Tolylreste, Xylylreste und Ethylphenylreste, und Aralkylreste, wie der Benzylrest, der α- und der β-Phenylethylrest.

Beispiele für substituierte Reste R sind Halogenalkylreste, wie der 3,3,3-Trifluor-n-propylrest, der 2,2,2,2',2`,2`-Hexafluorisopropylrest, der Heptafluorisopropylrest, Halogenarylreste, wie der o-, m- und p-Chlorphenylrest, -(CH₂)-N(R₂)C(O)NR²₂, - -(CH₂)ₙ-C(O)NR²₂, -(CH₂)ₙ-C(O)R², -(CH₂)ₙ-C(O)OR²,-(CH₂)n-C(O)NR²₂, - (CH₂)-C(O)- (CH₂)ₘC(O)CH₃, - (CH₂)-O-CO-R², - (CH₂)-NR²-(CH₂)ₘ-NR²₂, - -(CH₂)ₙ-O-(CH₂)ₘCH (OH) CH₂OH, - (CH₂)ₙ(OCH₂CH₂)ₘOR², - (CH₂)ₙ-SO₂-Ph und -(CH₂)ₙ-O-C₆F₅, wobei R² und Ph der oben dafür angegebene Bedeutung entspricht und n und m gleiche oder verschiedene ganze Zahlen zwischen 0 und 10 bedeuten.

Beispiele für R gleich zweiwertige, beidseitig gemäß Formel (II) Si-gebundene Reste sind solche, die sich von den voranstehenden für Rest R genannten einwertigen Beispiele dadurch ableiten, dass eine zusätzliche Bindung durch Substitution eines Wasserstoffatoms erfolgt, Beispiele für derartige Reste sind -(CH₂)-, -CH(CH₃)-, -C(CH₃)₂-, -CH(CH₃)-CH₂-, -C₆H₄-, -CH(Ph)-CH₂-, -C(CF₃)₂-, -(CH₂)ₙ-C₆H₄-(CH₂)ₙ-, - (CH₂)ₙ-C₆H₄-C₆H₄-(CH₂)ₙ-, - (CH₂O)ₘ, (CH₂CH₂O)ₘ, - (CH₂)ₙ-Oₓ-C₆H₄-SO₂-C₆H₄-Oₓ-(CH₂)ₙ-, wobei x 0 oder 1 ist, und Ph, m und n die voranstehend genannte Bedeutung haben.

Bevorzugt handelt es sich bei Rest R um einen einwertigen, von aliphatischen Kohlenstoff-Kohlenstoff-Mehrfachbindungen freien, SiC-gebundenen, gegebenenfalls substituierten Kohlenwasserstoffrest mit 1 bis 18 Kohlenstoffatomen, besonders bevorzugt um einen einwertigen, von aliphatischen Kohlenstoff-Kohlenstoff-Mehrfachbindungen freien, SiC-gebundenen Kohlenwasserstoffrest mit 1 bis 6 Kohlenstoffatomen, insbesondere um den Methyl- oder Phenylrest.

Bei Rest R¹ kann es sich um beliebige, einer Anlagerungsreaktion (Hydrosilylierung) mit einer SiHfunktionellen Verbindung zugängliche Gruppen handeln. Falls es sich bei Rest R¹ um SiC-gebundene, substituierte Kohlenwasserstoffreste handelt, sind als Substituenten Halogenatome, Cyanoreste und -OR² bevorzugt, wobei R² die obengenannte Bedeutung hat.

Bevorzugt handelt es sich bei Rest R¹ um Alkenyl- und Alkinylgruppen mit 2 bis 16 Kohlenstoffatomen, wie Vinyl-, Allyl-, Methallyl-, 1-Propenyl-, 5-Hexenyl-, Ethinyl-, Butadienyl-, Hexadienyl-, Cyclopentenyl-, Cyclopentadienyl-, Cyclohexenyl-, Vinylcyclohexylethyl-, Divinylcyclohexylethyl-, Norbornenyl-, Vinylphenyl- und Styrylreste, wobei Vinyl-, Allyl- und Hexenylreste besonders bevorzugt verwendet werden. Das Molekulargewicht des Bestandteils (A) kann in weiten Grenzen variieren, etwa zwischen 10² und 10⁶ g/mol. So kann es sich bei dem Bestandteil (A) beispielsweise um ein relativ niedermolekulares alkenylfunktionelles Oligosiloxan, wie 1,2-Divinyltetramethyldisiloxan, handeln, jedoch auch um ein über kettenständige oder endständige Si-gebundene Vinylgruppen verfügendes hochpolymeres Polydimethylsiloxan, z.B. mit einem Molekulargewicht von 10⁵ g/mol (mittels NMR bestimmtes Zahlenmittel).

Die erfindungsgemäße Additionsvernetzende Siliconzusammensetzung enthält bevorzugt 30-80 Gew.% (A) besonders bevorzugt 40-70 Gew.%(A).

Als Organosiliciumverbindung (B) können alle hydrogenfunktionellen Organosiliciumverbindungen eingesetzt werden, die auch bisher in additionsvernetzbaren Zusammensetzungen eingesetzt worden sind.

Als Organopolysiloxane (B), die Si-gebundene Wasserstoffatome aufweisen, werden vorzugsweise lineare Organopolysiloxane aus Einheiten der allgemeinen Formel (III)

R_{c}H_{d}SiO_{(4-c-d)/2} (III)

eingesetzt, wobei
**R** die oben angegebene Bedeutung hat,
**c** 0,1 2 oder 3 ist und
**d** 0, 1 oder 2 ist,
mit der Maßgabe, dass die Summe von c + d kleiner oder gleich 3 ist und mindestens zwei Si gebundene Wasserstoffatome je Molekül vorliegen.

Vorzugsweise enthält das erfindungsgemäß eingesetzte Organopolysiloxan (B) Si-gebundenen Wasserstoff im Bereich von 0,02 bis 1,7 Gewichtsprozent, bezogen auf das Gesamtgewicht des Organopolysiloxans (B).

Das Molekulargewicht des Bestandteils (B) kann ebenfalls in weiten Grenzen variieren, etwa zwischen 10² und 10⁶ g/mol. So kann es sich bei dem Bestandteil (B) beispielsweise um ein relativ niedermolekulares SiH-funktionelles Oligosiloxan, wie Tetramethyldisiloxan, handeln, jedoch auch um ein über kettenständig oder endständig SiH-Gruppen verfügendes hochpolymeres Polydimethylsiloxan oder ein SiH-Gruppen aufweisendes Siliconharz.

Auch die Struktur der den Bestandteil (B) bildenden Moleküle ist nicht festgelegt; insbesondere kann die Struktur eines höhermolekularen, also oligomeren oder polymeren SiH-haltigen Siloxans linear sein. Lineare Polysiloxane (B) sind vorzugsweise aus Einheiten der Formel R₃SiO_{1/2}, HR₂SiO_{1/2}, HRSiO_{2/2} und R₂SiO_{2/2} zusammengesetzt, wobei R die vorstehend angegebene Bedeutung hat.

Selbstverständlich können auch Mischungen unterschiedlicher, den Kriterien des Bestandteils (B) genügender Siloxane eingesetzt werden. Insbesondere können die den Bestandteil (B) bildenden Moleküle zusätzlich zu den obligaten SiH-Gruppen ggf. zugleich auch aliphatisch ungesättigte Gruppen enthalten. Besonders bevorzugt ist die Verwendung niedermolekularer SiHfunktioneller Verbindungen wie Tetrakis(dimethylsiloxy)silan und Tetramethylcyclotetrasiloxan, sowie höhermolekularer, SiHhaltiger Siloxane, wie Poly(hydrogenmethyl)siloxan und Poly(dimethylhydrogenmethyl)siloxan mit einer Viskosität bei 25°C von 10 bis 10 000 mPa•s, oder analoge SiH-haltige Verbindungen, bei denen ein Teil der Methylgruppen durch 3,3,3-Trifluorpropyl- oder Phenylgruppen ersetzt ist.

Die erfindungsgemäße Additionsvernetzende Siliconzusammensetzung enthält bevorzugt 0,5-20 Gew.% (B) besonders bevorzugt 1-15 Gew.%(B).

Bestandteil (B) ist vorzugsweise in einer solchen Menge in den erfindungsgemäßen vernetzbaren Siliconzusammensetzungen enthalten, dass das Molverhältnis von SiH-Gruppen zu aliphatisch ungesättigten Gruppen aus (A) bei 0,1 bis 20, besonders bevorzugt zwischen 0,2 und 2,0, liegt.
Die erfindungsgemäß eingesetzten Komponenten (A) und (B) sind handelsübliche Produkte bzw. nach in der Chemie gängigen Verfahren herstellbar.

Anstelle von Komponente (A) und (B) können die erfindungsgemäßen Siliconzusammensetzungen lineare Organopolysiloxane (C), die gleichzeitig aliphatische Kohlenstoff-Kohlenstoff-Mehrfachbindungen und Si-gebundene Wasserstoffatome aufweisen, enthalten. Auch können die erfindungsgemäßen Siliconzusammensetzungen alle drei Komponenten (A), (B) und (C) enthalten.

Falls Siloxane (C) eingesetzt werden, handelt es sich vorzugsweise um solche aus Einheiten der allgemeinen Formeln (IV), (V) und (VI)

R_{f}SiO_{4/2} (IV)

R_{g}R¹SiO_{3-g/2} (V)

RₕHSiO_{3-h/2} (VI)

wobei
**R** und **R¹** die oben dafür angegebene Bedeutung haben
**f** 1, 2 oder 3 ist,
**g** 1 oder 2 ist und
**h** 1 oder 2 ist,
mit der Maßgabe, dass je Molekül mindestens 2 Reste R¹ und mindestens 2 Si-gebundene Wasserstoffatome vorliegen.

Die erfindungsgemäße Additionsvernetzende Siliconzusammensetzung enthält bevorzugt 30-80 Gew.% (C) besonders bevorzugt 40-70 Gew.% (C).

Die Organopolysiloxane (C) besitzen vorzugsweise eine durchschnittliche Viskosität von 0,01 bis 500.000 Pa•s, besonders bevorzugt 0,1 bis 100.000 Pa•s jeweils bei 25°C. Organopolysiloxane (C) sind nach in der Chemie gängigen Methoden herstellbar.

Als Hydrosilylierungskatalysator (D) können alle dem Stand der Technik bekannten Katalysatoren verwendet werden. Komponente (D) kann ein Platingruppenmetall sein, beispielsweise Platin, Rhodium, Ruthenium, Palladium, Osmium oder Iridium, eine metallorganische Verbindung oder eine Kombination davon. Beispiele für Komponente (D) sind Verbindungen wie Hexachloroplatin(IV)-säure, Platindichlorid, Platinacetylacetonat und Komplexe der besagten Verbindungen, die in einer Matrix oder einer kernschalenartigen Struktur eingekapselt sind. Zu den Platinkomplexen mit niedrigem Molekulargewicht der Organopolysiloxane gehören 1,3-Diethenyl-1,1,3,3 - Tetramethyldisiloxan-Komplexe mit Platin. Weitere Beispiele sind Platinphosphitkomplexe, Platinphosphinkomplexe oder Alkylplatinkomplexe. Diese Verbindungen können in einer Harzmatrix eingekapselt sein.

Die Menge an Komponente (D) kann zwischen 0,1 und 1.000 Teile pro Million (ppm), 0,5 und 100 ppm oder 1 und 25 ppm des Platingruppenmetalls betragen, je nach Gesamtgewicht der Komponenten. Die Härtungsrate kann gering sein, wenn der Bestandteil des Platingruppenmetalls bei unter 1 ppm liegt. Die Verwendung von mehr als 100 ppm des Platingruppenmetalls ist unwirtschaftlich oder kann die Stabilität der Zusammensetzung verringern.

Der Füllstoff aus porösen Glaspartikeln (E) zeigt eine Gerüstdichte der Glasmatrix solcher im Sinne der Erfindung poröser Gläser zwischen 1,0 und 3,0 g/cm3. Die diesbezüglichen Porendurchmesser betragen 1,0 x 10⁻¹⁰ m bis 20 x 10⁻¹⁰ m, also 1 bis 20 Angström.

Die dotierten Glaspartikel (E) werden hergestellt durch das Zerkleinerung von Glasschaum bis zu einer mittleren Teilchengröße von 1 bis 50 µm, vorzugsweise 2 bis 15 µm, und dem anschließenden Vermischen mit einem gelöstem Silbersalz, vorzugsweise Silbernitratlösung. Es werden bezogen auf die Glaspartikel 1 bis 15 Gew.%, vorzugsweise 4 bis 7 Gew.% Silbersalzlösung eingemischt. Durch die Porosität der Glaspartikel wird die Silberlösung von diesen aufgenommen. Dabei verklumpen die Glaspartikel nicht. Anschließend erfolgt eine Temperierung/Trocknung, um die Silberionen teilweise an den Porenwänden der Glaspartikel über Ionenbindung zu fixieren und den Feuchtegehalt der silberhaltigen porösen Glaspartikel zu senken. Der Silbergehalt der porösen Glaspartikel beträgt 0,5 bis 30 Gew.%, vorzugsweise 1 bis 10 Gew.%, bezogen auf (E).

Vorzugsweise liegen 5 bis 50 Gew.%, besonders bevorzugt 15 bis 35 Gew.% des eingebrachten Silbers in ionischer Form - als Silberionen - vor.

Die erfindungsgemäße Silconelastomerzusammensetzung kann wahlweise als Bestandteile weitere Zusätze (F) zu einem Anteil von 0 bis zu 70 Gew.-%, vorzugsweise 1 bis 40 Gew.-%, enthalten. Diese Zusätze können, verstärkende und nicht verstärkende Füllstoffe die von (E) verschieden sind, rheologische Additive, flammabweisend machende Mittel und Mittel zur Beeinflussung der elektrischen Eigenschaften, Dispergierhilfsmittel, Lösungsmittel, Haftvermittler, Pigmente, Farbstoffe, Weichmacher, organische Polymere, Hitzestabilisatoren usw. sein. Beispiele für Haftvermittler die als Zusatzstoffe (F) verwendet werden können, sind Silane mit hydrolysierbaren Gruppen und SiC-gebundenen Vinyl-, Acryloxy-, Methacryloxy-, Epoxy-, Säureanhydrid-, Säure-, Ester- oder Ethergruppen sowie deren Teil- und Mischhydrolysate, wobei Silane mit Vinylgruppen und Silane mit Epoxygruppen, die als hydrolysierbare Reste Ethoxy- oder Acetoxygruppen enthalten, bevorzugt und Vinyltriethoxysilan, Vinyltriacetoxysilan, Epoxypropyltrimethoxysilan bzw. deren Teil- und Mischhydrolysate besonders bevorzugt sind. Die erfindungsgemäße Siliconzusammensetzung enthalten Haftvermittler (F) in Mengen von vorzugsweise 0 bis 5 Gew.%, bevorzugt 0,3 bis 3 Gew.%.

Die Kombination aus poröser Oberflächenstruktur mit einer Silberdotierung, die das Silber überwiegend in ionischer Form zur Bindung der schwefelhaltigen Schadgase bereit hält, hat sich als besonders wirkungsvoll gezeigt um vergossene elektronische Bauteile gegenüber Schwefelhaltigen Schadgasen zu schützen. Die erfindungsgemäßen additionsvernetzenden Siliconzusammensetzungen bieten durch die Komponente (E) mit seiner porösen Oberflächenstruktur eine deutlich höhere effektive Oberfläche zur Adsorption von Schadgasen an. Neben der erhöhten Oberfläche dieser Füllstoffe hat sich auch das überwiegend in ionischer Form vorliegende Silber als besonders vorteilhaft zum Schutz von metallischen Oberflächen gegenüber schwefelhaltigem Schadgas gezeigt.

Die erfindungsgemäßen Zusammensetzungen werden zum Verguß von elektrischen oder elektronischen Bauteilen verwendet.

Ein weiterer Gegenstand der vorliegenden Erfindung sind daher mit einem Verguß überzogene elektrische oder elektronische Bauteile, die dadurch gekennzeichnet sind, dass der Verguß eine polymerisierte erfindungsgemäße Siliconzusammenseztung ist.

### Beispiele

In den nachstehend beschriebenen Beispielen beziehen sich alle Angaben von Teilen und Prozentsätzen, falls nicht anders angegeben, auf das Gewicht. Sofern nicht anders angegeben, werden die nachstehenden Beispiele bei einem Druck der umgebenden Atmosphäre, also etwa bei 1.000 hPa, und bei Raumtemperatur, also bei etwa 20°C, bzw. bei einer Temperatur, die sich beim Zusammengeben der Reaktanden bei Raumtemperatur ohne zusätzliche Heizung oder Kühlung einstellt, durchgeführt. Im Folgenden beziehen sich alle Viskositätsangaben auf die dynamische Viskosität bei einer Temperatur von 20°C und einer Scherung von 1 s⁻¹. Die nachfolgenden Beispiele erläutern die Erfindung, ohne dabei beschränkend zu wirken. Alle Beispiele geben die Gesamtzusammensetzung der vernetzten Produkte wieder, ob diese als ein- oder zweikomponenten-Zusammensetzungen formuliert werden, spielt dabei keine Rolle.

### Beschreibung der Rohstoffe:

Vinylpolymere 1 und 2: Es handelt sich um vinyldimethylsiloxyterminerte Dimethylpolysiloxane mit unterschiedlichen Viskositäten die nach herkömmlichen Verfahren hergestellt wurden.

SiH-Vernetzer H018: Es handelt sich um eine trimethylsilylterminiertes Dimethyl/Methyl-Hydrogen-Copolysiloxan mit einer Viskosität von 180 mPa•s und einen H-Gehalt von 0,17 Gew.%.
H-Polymer: Es handelt sich um ein H-dimethylsiloxyterminiertes Dimethylpolysiloxan mit einer Viskosität von 65 mPa•s.
Katalysatorbatch EP: Karstedt-Katalysator mit 1 Gew.% Platin in PDMS.
Füllstoff 1: Amorphe, poröse Silikatglaspartikel, typischer Partikeldurchmesser ca. 10 µm, Silbergehalt 3,1 Gew.%, Silberionengehalt 0,26 mg/L
Füllstoff 2: Amorphe, poröse Silikatglaspartikel, typischer Partikeldurchmesser ca. 10 µm, Silbergehalt 3,1 Gew.%, Silberionengehalt 0,37 mg/L
Füllstoff 3: Amorphe, poröse Silikatglaspartikel, typischer Partikeldurchmesser ca. 10 µm, Silbergehalt 7,6 Gew%, Silberionengehalt 2,4 mg/L
Füllstoff 4: Sphärische Silikatglaspartikel mit metallischem Silber gecoatet, Partikeldurchmesser 15-50 µm, Dichte 2,6 g/cm3, Silbergehalt 8,0 Gew%,
Füllstoff 5: Sphärische Kupfermetallpartikel mit metallischem Silber gecoatet, Partikeldurchmesser 10-30 µm, Silbergehalt 17,0 Gew.%,

### Beschreibung der Siliconzusammensetzungen und Tests:

Die Zusammensetzungen wurden in geeigneten Mischern gemischt. Nach dem Mischen wurden die Siliconzusammensetzungen bei 10 mbar für 5 min entgast. Der Füllstoffgehalt (Füllstoffe 1 bis 5) betrug immer 50 Gew.% bezogen auf die Gesamtformulierung.

Korrosionstest: Die Testsubstrate bestanden aus 1mm starker Aluminiumoxydkeramik auf die Silberleiterbahnen in Mäanderstruktur gedruckt wurden. Die Leiterbahnen wiesen eine Bahnbreite von 0,5 mm auf. Die fließfähigen Mischungen 1 - 6 werden auf die Testsubstrate in 2 mm Schichtdicke appliziert, entgast und für 60 min bei 150°C ausgehärtet. Es werden weiche Silicon Gele erhalten.
Die Testsubstrate wurden zusammen mit 1g elementarem Schwefelpulver in einen 1 L-Exsikator gelegt. Der Exsikator wurde verschlossen und für insgesamt 14 Tage auf 80°C erhitzt. Nach definierten Zeitintervallen wurden die Testsubstrate entnommen, das Silicon Gel entfernt und die Silberleiterbahn visuell auf Korrosion geprüft.
Das Testmuster wurde als positiv (pos) beurteilt, wenn sich die Silberbahn nicht verfärbt hatte und metallischen Glanz aufwies. Das Testmuster wurde als negativ (neg) beurteilt wenn, sich die Silberbahn dunkel oder schwarz verfärbt hatte, was Korrosion anzeigt.

Tabelle 1 zeigt die Zusammensetzung der Beispiele 1-6 sowie die Ergebnisse des Korrosionstestes.

Beispiele 1-4 erfindungsgemäß: Siliconzusammensetzungen mit Füllstoffen aus amporphen, porösen Silikatpartikeln und überwiegend ionischem Silbercoating.

Beispiel 5, nicht erfindungsgemäß, mit sphärischen Silikatglaspartikeln und metallischem Silbercoating.

Beispiel 6, nicht erfindungsgemäß, mit sphärischen Kupfermetallpartikeln und metallischem Silbercoating analog EP1295905A1.

Die erfindungsgemäßen Beispiele 1-4 zeigen, dass nur die erfindungsgemäßen Siliconzusammensetzungen mit amporphen, porösen Silikatpartikeln und überwiegend ionischer Silberdotierung einen dauerhaften und nachhaltigen Schutz der zu schützenden Substrate, und somit der elektronischen Bauteile, ermöglichen.

**Tabelle 1:**

| **Zusammensetzungen jeweils in Gew.teilen** | | | | | | |
|---|---|---|---|---|---|---|
| **Beispiel** | **1** | **2** | **3** | **4** | **5*** | **6*** |
| Vinylpolymer 1: 200 mPa•s | - | 100 | - | 100 | - | 100 |
| Vinylpolymer 2: 1.000 mPas | 100 | - | 100 | - | 100 | - |
| H-Polymer: 65 mPa•s | - | 25 | - | 25 | - | 25 |
| SiH Vernetzer H018 | 3,0 | 0,5 | 3,0 | 0,5 | 3,0 | 0,5 |
| Katalysatorbatch EP | 0,2 | 0,2 | 0,2 | 0,2 | 0,2 | 0,2 |
| Füllstoff 1 | 103,2 | 125,7 | - | - | - | - |
| Füllstoff 2 | - | - | 103,2 | - | - | - |
| Füllstoff 3 | - | - | - | 125,7 | - | - |
| Füllstoff 4 | - | - | - | - | 103,2 | - |
| Füllstoff 5 | - | - | - | - | - | 125,7 |

| ***Korrosionstest*** | | | | | | |
|---|---|---|---|---|---|---|
| nach 24 h | pos | pos | pos | pos | pos | pos |
| nach 72 h | pos | pos | pos | pos | *neg* | pos |
| nach 168 h | pos | pos | pos | pos | *neg* | *neg* |
| nach 336 h | pos | pos | pos | pos | *neg* | *neg* |

| | | | | | | |
|---|---|---|---|---|---|---|
| * nicht erfindungsgemäß | | | | | | |

## Patentansprüche

1. Additionsvernetzende Siliconzusammensetzungen enthaltend,
(A) 30-95 Gew.% lineare Verbindungen, die Reste mit aliphatischen Kohlenstoff-Kohlenstoff-Mehrfachbindungen aufweisen,
(B) 0,1-20 Gew.% lineare Organopolysiloxane mit Si-gebundenen Wasserstoffatomen,
oder anstelle von (A) und (B)
(C) 30-95 Gew.% lineare Organopolysiloxane, die SiC-gebundene Reste mit aliphatischen Kohlenstoff-Kohlenstoff Mehrfachbindungen und Si-gebundene Wasserstoffatome aufweisen,
(D) mindestens einen Hydrosilylierungskatalysator, und
(E) 5 bis 70 Gew.% Füllstoff aus porösen Glaspartikeln die mit Silber dotiert sind, wobei 5 bis 50 Gew.% des Silbers in ionischer Form dotiert sind.

2. Verfahren zur Herstellung von additionsvernetzenden Siliconzusammenseztungen gemäß Anspruch 1, durch Mischen der Komponenten (A), (B), (D) und (E) oder (C), (D) und (E).

3. Verwendung der Zusammensetzungen gemäß Anspruch 1 zum Verguß von elektrischen oder elektronischen Bauteilen.

4. Mit einem Verguß überzogene elektrische oder elektronische Bauteile, **dadurch gekennzeichnet, dass** der Verguß eine polymeriserte Siliconzusammenseztungen gemäß Anspruch 1 ist.

## Claims

1. Addition-crosslinking silicone compositions comprising
(A) from 30 to 95% by weight of linear compounds which have moieties having aliphatic carbon-carbon multiple bonds,
(B) from 0.1 to 20% by weight of linear organopolysiloxanes having Si-bonded hydrogen atoms,
or instead of (A) and (B)
(C) from 30 to 95% by weight of linear organopolysiloxanes which have SiC-bonded moieties having aliphatic carbon-carbon multiple bonds and Si-bonded hydrogen atoms,
(D) at least one hydrosilylation catalyst, and
(E) from 5 to 70% by weight of filler made of porous silver-doped glass particles, where from 5 to 50% by weight of the silver have been doped in ionic form.

2. Process for the production of addition-crosslinking silicone compositions according to Claim 1, via mixing of components (A), (B), (D), and (E), or (C), (D), and (E).

3. Use of the compositions according to Claim 1 for the encapsulation of electrical or electronic components.

4. Encapsulated electrical or electronic components, **characterized in that** the encapsulation material is a polymerized silicone composition according to Claim 1.

## Revendications

1. Compositions de silicone réticulant par addition, contenant
(A) 30 à 95 % en poids de composés linéaires, qui comprennent des radicaux contenant des liaisons carbone-carbone multiples aliphatiques,
(B) 0,1 à 20 % en poids d'organopolysiloxanes linéaires contenant des atomes d'hydrogène reliés à Si, ou au lieu de (A) et (B)
(C) 30 à 95 % en poids d'organopolysiloxanes linéaires, qui comprennent des radicaux reliés à SiC contenant des liaisons carbone-carbone multiples aliphatiques et des atomes d'hydrogène reliés à Si,
(D) au moins un catalyseur d'hydrosilylation, et
(E) 5 à 70 % en poids d'une charge constituée de particules de verre poreuses dopées avec de l'argent, 5 à 50 % en poids de l'argent étant utilisé pour le dopage sous forme ionique.

2. Procédé de fabrication de compositions de silicone réticulant par addition selon la revendication 1, par mélange des composants (A), (B), (D) et (E) ou (C), (D) et (E).

3. Utilisation des compositions selon la revendication 1 pour le scellement de composants électriques ou électroniques.

4. Composants électriques ou électroniques enrobés avec un scellement, **caractérisés en ce que** le scellement est une composition de silicone polymérisée selon la revendication 1.
